Europäisches Patentamt

European Patent Office

Office européen des brevets

(19)

(11) EP 0 749 208 A2

(12) EUROPEAN PATENT APPLICATION

(43) Date of publication:
18.12.1996 Bulletin 1996/51

(51) Int Cl.6: H03K 17/082

(21) Application number: 96304040.7

(22) Date of filing: 04.06.1996

(84) Designated Contracting States:
DE FR GB

(30) Priority: 15.06.1995 US 490688

(71) Applicant: AT&T IPM Corp.
Coral Gables, Florida 33134 (US)

(72) Inventors:
• Law, Ronald Leavitt
  Allen, Texas 75002 (US)

• Roy, Apurba
  Rockwall, Texas 75087 (US)

(74) Representative:
Buckley, Christopher Simon Thirsk
Lucent Technologies,
5 Mornington Road
Woodford Green, Essex IG8 0TU (GB)

(54) Field effect transistor protection circuit

(57) A field effect transistor ("FET") (130) protection circuit (300) for modifying a drive signal provided (from 110, 120) to the FET comprises: (1) a voltage-sense circuit (310) coupled to the FET (130) to measure an operating voltage across the FET, the operating voltage being a function of both a magnitude of an electrical current flowing through the FET and an operating temperature of the FET and (2) a drive signal modification circuit (320) coupled to the voltage-sense circuit, the drive signal modification circuit modifying the drive signal when the operating voltage exceeds a predetermined limit voltage, the protection circuit thereby providing unified overcurrent and overtemperature protection for the FET.

FIG. 3

## Description

## TECHNICAL FIELD OF THE INVENTION

The present invention is directed, in general, to a protection circuit for a transistor and, more specifically, to a protection circuit for a field effect transistor ("FET") that senses a total voltage across the FET, the total voltage being a function of both through-current flowing through the FET and the operating temperature of the FET, the circuit modifying operation of the FET when the total voltage exceeds a predetermined limit.

## BACKGROUND OF THE INVENTION

It is well known that if a transistor or, more specifically, a FET exceeds a predetermined operating temperature or through-current condition during operation, there is a substantial likelihood of failure or damage to the FET. To avoid such a condition, FET manufacturers publish specifications that indicate the maximum allowable operating junction or die temperature and through-current for the FET. Failures can occur when the maximum allowable junction temperature is exceeded, or when excessive current passes through the die of the FET.

Some prior systems provide overtemperature protection for the transistor by providing an additional temperature-sensing element, comprising a diode or thermistor, in close proximity to the FET package to sense the FET temperature. The FET is then turned off when the sensed temperature exceeds some maximum limit. In such prior art systems, there is typically poor thermal coupling between the temperature-sensing element and the FET die, so that the sensed temperature does not accurately represent the actual FET temperature. To compensate for this error, the maximum limit may be lowered to provide a margin of safety, even though the maximum actual FET temperature may not have been reached. While this additional margin of safety protects the FET, it interrupts the normal circuit conditions prematurely and thereby compromises performance. Further, providing an additional temperature sensing element in close proximity to the FET complicates and increases the cost of the resulting circuit.

In an effort to provide more comprehensive protection for FETs, some prior art systems have included both overcurrent and overtemperature protection circuits. U. S. Patent No. 4,896,245 to Qualich, issued on January 23, 1990, and entitled "FET Overtemperature Protection Circuit," attempts to provide an improved transistor overtemperature protection circuit that monitors die temperature without using an additional temperature-sensing element. More specifically, a first signal related to the FET drain to source voltage is compared to a second signal related to the FET source current. If the first signal exceeds the second signal by a predetermined amount, the FET is turned off. This corresponds to shutting down the FET when the drain to source on-resistance of the FET exceeds a FET on-resistance value corresponding to a maximum allowable FET die temperature. Thus, the FET is turned off for excessive die temperatures to prevent damage to the FET. Also, Qualich employs the second, FET source current signal to provide source current short circuit protection to the FET.

While Qualich provides two levels of protection for the FET, Qualich uses two separate protection circuits to accomplish the protection. Unfortunately, Qualich fails to account for the interdependence between the operating temperature (including the ambient temperature conditions) and the through-current of the FET. As a general rule, FET maximum allowable operating temperature and through-current are inversely related to one another. In other words, the maximum allowable operating temperature of the FET can increase if the through-current is relatively low. Correspondingly, the maximum allowable through-current of the FET can increase if the operating temperature is relatively low.

The independent current and temperature protection circuits of Qualich therefore have two significant limitations. First, Qualich fails to take into account the interdependent relationship of the operating temperature and through-current in the FET protection circuit. Qualich thus fails to account for variations in device and circuit packaging and ambient environmental conditions, such as cooling air flow rate and temperature, into its design. The probability of nuisance trips is increased in independent protection circuits such as those taught in Qualich, since the independent circuits are set to the independent through-current and temperature limits.

Second, the multiple circuits of Qualich are more expensive and complex and physically larger than they need be. For instance, Qualich dictates the use of a comparator to compare the drain to source FET voltage to the voltage indicative of the FET source through-current. The comparator trips when the drain to source FET voltage exceeds the voltage indicative of the FET source through-current by a predetermined limit.

Accordingly, what is needed in the art is a simplified, unified overcurrent and overtemperature FET protection circuit that takes into account the interdependence of through-current and operating temperature.

## SUMMARY OF THE INVENTION

To address the above-discussed deficiencies of the prior art, the present invention provides a FET protection circuit for modifying a drive signal provided to a FET and a method of protecting a FET. The protection circuit comprises: (1) a voltage-sense circuit coupled to the FET to measure an operating voltage across the FET, the operating voltage being a function of both a magnitude of an electrical through-current flowing through the FET and an operating temperature of the FET and (2) a drive signal modification circuit coupled to the voltage-sense circuit, the drive signal modification circuit modifying the drive signal when the operating voltage exceeds a predetermined limit voltage, the protection circuit thereby providing unified overcurrent and overtemperature protection for the FET. Thus, in contrast to the prior art, the present invention unifies the overcurrent and overtemperature protection circuits to take into account the interdependence of through-current and operating temperature on the operation of a FET.

In a preferred embodiment of the present invention, the voltage-sense circuit comprises a voltage mirror circuit coupled in parallel with the FET, the voltage mirror circuit creating a voltage therein equivalent to the operating voltage of the FET. Those of ordinary skill in the art will understand that voltage-sense circuits other than a voltage mirror circuit are within the broad scope of the present invention. For instance, the through-current and resistance of the FET can be measured and the voltage thereacross derived.

In a preferred embodiment of the present invention, the FET is a metal oxide semiconductor FET ("MOSFET"). Non-MOSFET devices are, however, within the broad scope of the present invention.

In a preferred embodiment of the present invention, the protection circuit further comprises a voltage-sense controller circuit, coupled to the drive signal modification circuit, for disabling the drive signal modification circuit when the FET is in an "off" state. For reasons to be enumerated, it is preferable, but not necessary, to enable the protection circuit only when the FET is in an "on" state.

In a preferred embodiment of the present invention, a FET drive circuit provides the drive signal to the FET. The protection circuit modifies by disabling or interrupting the drive signal to the FET, preventing the FET from failing due to continued operation.

In a preferred embodiment of the present invention, the voltage-sense circuit comprises first and second transistors coupled together via respective control terminals thereof and a first resistive component coupling the FET and the second transistor. In a manner to be shown, this arrangement forms a mirror circuit, allowing the voltage across the FET to be mirrored across the first resistive component. The first resistive component is more preferably coupled in series with a second resistive component to form a ladder whose midpoint has a voltage varies as a function of the FET voltage. The midpoint is more preferably coupled to the base of a transistor; the transistor more preferably provides a signal to disable the drive signal. The second resistive component of said voltage-sense circuit having a desired resistance, the second resistive component producing a voltage across the drive signal modification circuit as a function of a through-current flow thereacross.

Another aspect of the present invention is a power converter comprising a power train having an input couplable to a source of electrical power, an output couplable to an electrical load and power conversion circuitry coupling the input to the output, the power conversion circuitry including a field effect transistor (FET), a FET drive circuit and a FET protection circuit for modifying a drive signal provided to the FET by the FET drive circuitry. The FET protection circuit is constructed according to the present invention as broadly defined above.

The foregoing has outlined, rather broadly, preferred and alternative features of the present invention so that those skilled in the art may better understand the detailed description of the invention that follows. Additional features of the invention will be described hereinafter that form the subject of the claims of the invention. Those skilled in the art should appreciate that they can readily use the disclosed conception and specific embodiment as a basis for designing or modifying other structures for carrying out the same purposes of the present invention. Those skilled in the art should also realize that such equivalent constructions do not depart from the spirit and scope of the invention in its broadest form.

## BRIEF DESCRIPTION OF THE DRAWINGS

For a more complete understanding of the present invention, and the advantages thereof, reference is now made to the following descriptions taken in conjunction with the accompanying drawings, in which:

FIGURE 1 illustrates a block diagram of a power conversion circuit employing a prior art thermal-sense protection circuit;

FIGURE 2 illustrates a block diagram of the power conversion circuit of FIGURE 1 employing a prior art current-sense protection circuit;

FIGURE 3 illustrates a block diagram of the power conversion circuit of FIGURE 1 employing the unified FET protection circuit of the present invention;

FIGURE 4 illustrates a schematic diagram of an embodiment of the unified FET protection circuit of the present invention;

FIGURE 5 illustrates a schematic diagram of an alternative embodiment of the unified FET protection circuit of the present invention; and

FIGURE 6 illustrates a schematic diagram of a buck-type DC-DC converter employing the embodiment of the unified FET protection circuit illustrated in FIGURE 4.

## DETAILED DESCRIPTION

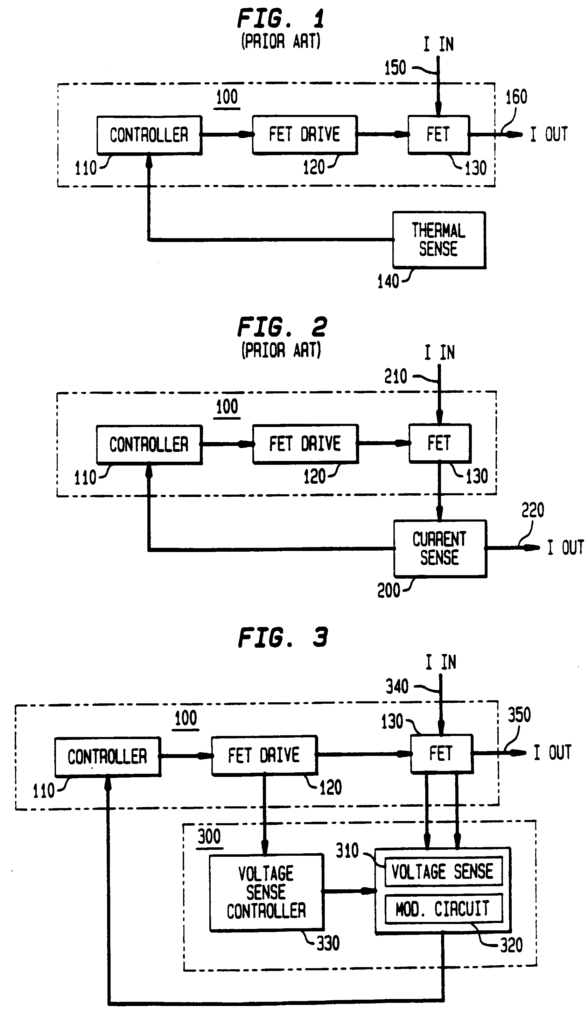

Referring initially to FIGURE 1, illustrated is a block diagram of a power conversion circuit 100 employing a prior art thermal-sense protection circuit 140. The thermal-sense protection circuit 140 also includes a thermal-sense device (not shown) associated therewith. The power conversion circuit 100 comprises a controller 110, a FET drive 120 and a FET 130. The thermal-sense protection circuit 140 is coupled to the power conversion circuit 100. When used in a typical power conversion application, the controller 110 operates at a specified frequency with some form of feedback (not shown) from the output. The FET drive 120 drives the FET 130 in one of two states (ie. "on" or "off") with relatively short transitions evident therebetween. When the FET 130 is in the "on" state, a current $I_{IN}$ 150 enters the FET 130 and a current $I_{OUT}$ 160 exits the FET 130. During the "on" state, the FET 130 will exhibit a resistance characteristic of the device plus some offset for the temperature of the junction or die of the device.

The thermal-sense protection circuit 140 is usually placed in close proximity of the FET 130 or, alternatively, the thermal-sense protection circuit 140 may be integrated on to the substrate of the FET 130. In either case, the thermal-sense protection circuit 140 measures the die temperature of the FET 130. The output of the thermal-sense protection circuit 140 is conditioned and fed back to the controller 110 to disable the FET 130 through the FET drive 120 when a predetermined FET die temperature is exceeded.

As previously mentioned, power conversion circuits 100 employing the thermal-sense protection circuit 140 are primarily deficient for a couple of different reasons. First, there is typically poor thermal coupling between the thermal-sense protection circuit 140 and the die of the FET 130. Thus, very often the sensed die temperature is not accurately representative of the actual temperature of the FET 130. This is especially apparent with an external thermal-sense protection circuit 140. Additionally, providing an additional thermal-sense protection circuit 140 in proximity to the FET 130 complicates and increases the cost of the resulting circuit that now includes the FET 130 and the thermal-sense protection circuit 140.

Turning now to FIGURE 2, illustrated is a block diagram of the power conversion circuit 100 of FIGURE 1 employing a prior art current-sense protection circuit 200. The power conversion circuit 100 comprises the controller 110, the FET drive 120 and the FET 130. The current-sense protection circuit 200 is coupled to the power conversion circuit 100. Again, typical power conversion is achieved by the controller 110 operating at a specified frequency with some form of feedback (not shown) from the output. In the illustrated power conversion circuit 100, all the through-current that flows through the FET 130 must also flow through the current-sense protection circuit 200. The FET drive 120 drives the FET 130 in one of two states (ie. "on" or "off") with relatively short transitions evident therebetween. Thus, when the FET 130 is in the "on" state, a current $I_{IN}$ 210 enters the FET 130, traverses the current-sense protection circuit 200, and a current $I_{OUT}$ 220 exits the current-sense protection circuit 200.

The current-sense protection circuit 200 is usually placed in close proximity of the FET 130 or, alternatively, the current-sense protection circuit 200 may be integrated on to the substrate of the FET 130. In any event, the voltage developed across the current-sense protection circuit 200 is either fed directly back to the controller 110 or conditioned prior to being sent back to the controller 110. The voltage is independent of the temperature of the FET 130 and reflects the current flowing through the device.

As previously mentioned, power conversion circuits 100 employing the current-sense protection circuit 200 are primarily deficient for the following reason. These systems do not accurately turn off the FET 130 in accordance with the actual die temperature. Thus, the current-sense protection circuit 200 does not effectively monitor actual temperature and can prematurely interrupt normal FET 130 operation before the maximum allowable temperature of the FET 130 is realized.

Turning now to FIGURE 3, illustrated is a block diagram of the power conversion circuit 100 of FIGURE 1 employing the unified FET protection circuit 300 of the present invention. The power conversion circuit 100 comprises the controller 110, the FET drive 120 and the FET 130. The unified FET protection circuit 300 is coupled to the power conversion circuit 100. The unified FET protection circuit 300 comprises a FET voltage-sense circuit 310, a drive signal modification circuit 320 and a voltage-sense controller 330. Once again, typical power conversion is achieved by the controller 110 operating at a specified frequency with some form of feedback (not shown) from the output. The FET drive 120 drives the FET 130 in one of two states (ie. "on" or "off") with relatively short transitions evident therebetween. When the FET 130 is in the "on" state, a current $I_{IN}$ 340 enters the FET 130 and a current $I_{OUT}$ 350 exits the FET 130. During the "on" state, the FET 130 will exhibit a resistance characteristic of the device plus some offset for the temperature of the junction or die of the device.

As current flows through the FET 130, a voltage is developed across the FET 130. The FET voltage-sense circuitry 310, located in close proximity to the FET 130, then conditions the voltage. The drive signal modification circuit 320, coupled to the voltage-sense circuit 310, then feeds a signal back to the controller 110 thereby requesting the controller 110 to disable the FET 130 through the FET drive 120 when conditions are exceeded. The voltage-sense controller 330 enables the voltage-sense circuitry 310 and the drive signal modification circuitry 320 only when the FET 130 is in the "on" state.

The following equations provide the theoretical basis for the basic operation of the unified FET protection circuit 300 of the present invention.

$$R_{DS}(T) = R_0 + \alpha T \qquad (1)$$

$$T(I, \beta) = T_0 + \beta I \qquad (2)$$

$$R_{DS} = R_0 + \alpha T_0 + \alpha \beta I \qquad (3)$$

$$V_{DS} = IR_{DS} = IR_0 + \alpha IT_0 + \alpha \beta I^2 \qquad (4)$$

Equation 1 indicates the relationship between the drain to source on-resistance ("$R_{DS}$") and the die temperature of the FET 130. In equation 1, $R_0$ is the on-resistance of the FET 130 at a reference temperature of, typically, 0°C; T is the FET 130 dietemperature in °C; and $\alpha$ is a parameter related to the inverse of the mobility of the charged carrier. Equation 2 illustrates the functional relationship between the die temperature and the through-current of the FET 130. In equation 2, $T_0$ is the ambient temperature; $\beta$ is an experimentally-derived parameter representing the packaging of the FET 130 and the airflow conditions; and I is the through-current of the FET 130.

It is important to note that the die temperature and through-current of the FET 130 are related, but that the rise in die temperature as a function of through-current also depends upon a combination of the circuit packaging and the airflow conditions. Therefore, the operating temperature of the FET 130 effectively begins at the ambient temperature of the circuit environment; the severity of the rise in temperature of the FET 130, in the "on" state, depends thereon upon the extraneous factors of the circuit packaging and the airflow conditions.

Equation 3 results from a substitution of equation 2 into equation 1 thereby demonstrating that $R_{DS}$ is not only a function of the die temperature of the FET 130, but is also a function of the through-current of the FET 130. Furthermore, through $\beta$, this relationship takes into account ambient temperature, a function of both circuit packaging and airflow conditions. Finally, equation 4 indicates the voltage parameter that the unified FET protection circuit 300 is monitoring. In short, the drain to source voltage ("$V_{DS}$") is equal to the actual through-current multiplied by $R_{DS}$. Thus, applying actual through-current to equation 3 yields the $V_{DS}$ of equation 4.

In theory and operation the unified FET protection circuit 300 of the present invention is quite simple. Suppose that the maximum allowable operating temperature of the FET 130 is 150 degrees Celsius. The voltage-sense circuitry 310 would then be set such that the maximum allowable drain to source voltage would correspond to an operating temperature of the FET 130 less than 150 degrees Celsius for a given packaging, airflow and ambient conditions. If the voltage-sense circuitry 310 senses a voltage corresponding to a higher operating temperature, then the drive signal modification circuit 320 sends a signal to the controller 110 to disable the FET 130. Thus, in contrast to the prior art, the present invention unifies the overcurrent and overtemperature protection circuits to take into account the interdependence of current and temperature on the operation of the FET 130.

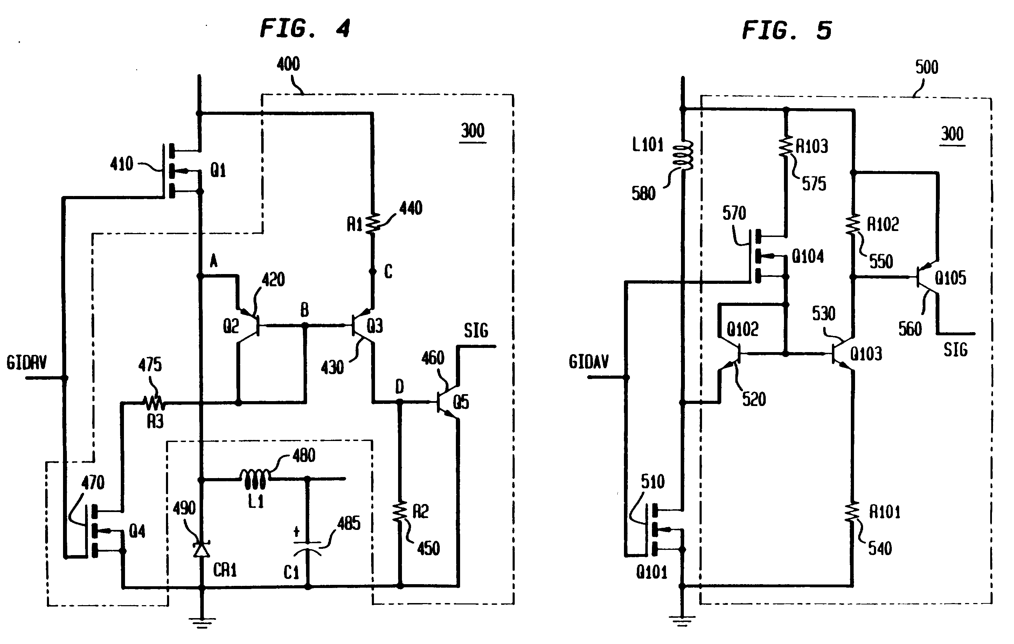

Turning now to FIGURE 4, illustrated is a schematic diagram of an embodiment of the unified FET protection circuit 300 (enclosed within a dashed line 400) of the present invention. The unified FET protection circuit 300 is employed to protect a FET 410 from excessive overtemperature and overcurrent conditions. The unified FET protection circuit 300 senses a total voltage across the FET 410. Again, the total voltage is a function of both the current flowing through the FET 410 and the operating temperature of the FET 410. The unified FET protection circuit 300 modifies the operation of the FET 410 when the total voltage exceeds a predetermined limit.

The voltage-sense circuitry of the illustrated embodiment comprises a voltage mirror circuit coupled in parallel with the FET 410. The voltage mirror circuit consists of a pair of transistors 420, 430 and a pair of resistors 440, 450. The voltage mirror circuit creates a voltage therein proportional to the operating voltage of the FET 410.

The illustrated embodiment operates as follows. A FET driver (not shown) provides a signal to the gate of the FET 410 thereby driving the device in to the "on" state. A current and voltage reflecting the source current enters the emitter of the transistor 420 at a point A. A voltage drop occurs across the transistor 420 resulting in, for instance, a 0.6 voltage drop from point A to a point B. Thereafter, a corresponding voltage drop occurs across the transistor 430 resulting in an equal voltage drop from point B to a point C.

The configuration of the transistors 420, 430 act as a voltage mirror across their respective emitters. Therefore, the mirrored voltage across the resistor 440 ("a first resistive component") in the voltage-sense circuit is the total voltage across the FET 410. While the transistors 420, 430 are illustrated as discrete components, it should be understood that it is within the scope of the present invention to integrate the components into a single package. Furthermore, it is also within the scope of the present invention to integrate the FET 410 and the transistors 420, 430 into a single package.

The first resistive component 440 is illustrated as coupled in series with the resistor 450 ("a second resistive component") to form a ladder whose midpoint has a voltage that varies as a function of the voltage of the FET 410. For a given voltage drop across the first resistive component 440, a current flows through the second resistive component 450 in the voltage-sense circuit. It is important to note that the resistance values of the resistors 440, 450 are selected based upon the operating conditions of the circuit; the resistors 440, 450 thereby set the predetermined voltage limits to protect the FET 410.

Based upon the value of the second resistive component 450 and the known current flowing therethrough, a maximum voltage is monitored at the base of a transistor 460 at a point D. If the voltage at point D exceeds the predetermined limit, it will actuate the transistor 460 thereby sending a signal to the controller (not shown) to disable the FET 410. The transistor 460, therefore, represents the drive signal modification circuit of the present invention. Additionally, it is also within the scope of the present invention for the drive signal modification circuit to furnish a signal to an alarm circuit or to a comparator with a reference voltage to ultimately protect the FET 410.

The unified FET protection circuit 300 also includes a voltage-sense controller. The voltage-sense controller circuit comprises a FET 470 and a resistance component 475 tied to the collector of the transistor 420 and the base of the transistor 430. The FET 470 is employed to gate the voltage of the transistors 420, 430 off when the FET 410 is off. This is accomplished by turning the FET 470 off when the FET 410 is off. As a result, the voltage across the transistors 420, 430 increase thereby disabling the transistors 420, 430. Thus, the voltage-sense controller circuit shuts down the voltage-sense circuit during the off time of the main FET.

The voltage-sense controller circuit is included primarily for a couple of different reasons. First, when the FET 410 is off, the voltage is at a maximum across the FET 410 leading to a comparably high potential across the resistor 440. This resulting high voltage circuit condition may, in turn, damage the voltage-sense circuit. Furthermore, the high voltage circuit condition may induce the transistor 460, comprising the drive signal modification circuit, to distort the drive signal to the FET 410. Therefore, the voltage-sense controller circuit turns off the transistors 420, 430 to protect the circuit.

Finally, the FET 410 is coupled through the unified FET protection circuit 300 to the remainder of the power circuit. The FET 410 in combination with an inductor 480, a capacitor 485 and a diode 490 comprises a buck-type regulator. The buck-type regulator is a switching power supply that "chops" the input voltage and applies the pulses to an averaging inductive-capacitive ("LC") filter. The LC filter, including the inductor 480 and the capacitor 485, in association with the diode 490 temper the input voltage to an output voltage level acceptable for a load.

Turning now to FIGURE 5, illustrated is a schematic diagram of an alternative embodiment of the unified FET protection circuit 300 (enclosed within a dashed line 500) of the present invention. The unified FET protection circuit 300 is employed to protect a FET 510 from excessive overtemperature and overcurrent conditions. The unified FET protection circuit 300 senses a total voltage across the FET 510. Again, the total voltage is a function of both the current flowing through the FET 510 and the operating temperature of the FET 510. The unified FET protection circuit 300 modifies the operation of the FET 510 when the total voltage exceeds a predetermined limit.

Analogous to the circuit of FIGURE 4, the voltage-sense circuitry of the illustrated embodiment comprises a voltage mirror circuit coupled in parallel with the FET 510. The voltage mirror circuit consists of a pair of transistors 520, 530 and a pair of resistors 540, 550. The voltage mirror circuit creates a voltage therein proportional to the operating voltage of the FET 510. Again, while the FET 510 and the transistors 520, 530 are illustrated as discrete componentry, it is well within the scope of the present invention to integrate the components into a single package.

The illustrated embodiment is an equivalent, reversed implementation of the circuit of FIGURE 4. For a given voltage drop across the resistor ("a first resistive component") 540, a known current flows through the resistor ("a second resistive component") 550. Based upon the value of the second resistive component 550 and the known current flowing therethrough, a maximum voltage is monitored at the base of the transistor 560. If the voltage exceeds the predetermined limit, it will actuate the transistor 560 thereby sending a signal to a controller (not shown) to disable the FET 510. The transistor 560, therefore, represents the drive signal modification circuit of the present invention.

The unified FET protection circuit 300 also includes a voltage-sense controller. The voltage-sense controller circuit comprises a FET 570 and a resistance component 575 tied to the collector of the transistor 520 and the base of the transistor 530. The FET 570 is employed to gate the voltage of the transistors 520, 530 off, when the FET 510 is off. The purpose and advantages of the voltage-sense controller circuit are discussed with respect to FIGURE 4. Finally, the FET 510 is shown coupled through the unified FET protection circuit 300 to an inductive load 580.

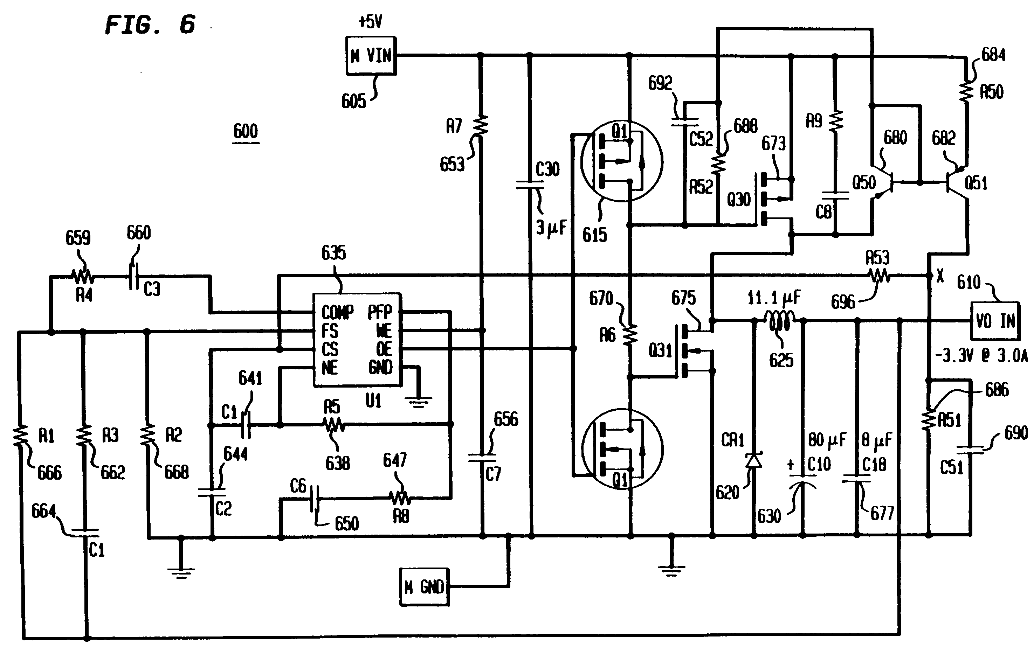

Turning now to FIGURE 6, illustrated is a schematic diagram of a buck-type DC-DC converter 600 (hereinafter designated as a "converter circuit") employing the embodiment of the unified FET protection circuit illustrated in FIGURE 4. With a buck-type DC-DC converter 600 the DC output voltage ("$V_{OT}$") 610 is always lower than the DC input voltage ("$V_{IN}$") 605. For instance, in the illustrated embodiment, the input voltage 605 is +5 V (provided by a source of electrical power, not shown) and the corresponding output voltage 610 is +3.3 V at 3 amperes of current (provided to an electrical load, not shown). The preferred operating frequency of the converter circuit 600 is 550 kHz.

The converter circuit 600 comprises the following components. A power MOSFET 615 (in the illustrated embodiment a Siliconix 9942DY manufactured by the Siliconix Corporation of Santa Clara, California) is connected in series with the input voltage 605. The power MOSFET 615 serves as the FET drive for the converter circuit 600. The output of the power MOSFET 615 is then connected to the cathode of a diode 620 and an inductor 625. The output side of the inductor 625 is connected to a capacitor 630 and is the point where the output voltage 610 is available.

The anode of the diode 620 is connected to the output return and the negative side of the capacitor 630. The output voltage 610 is regulated by varying the duty cycle of the power MOSFET 615. The inductor 625 in combination with the capacitor 630 form a filter to average the square wave voltage generated by the on/off cycles of the power MOSFET 615. The diode 620 provides a path for continued current flow when the power MOSFET 615 is off. The relationship of the output to input voltage is expressed as follows:

$$V_{OT} = (t_{on} / T_s) * V_{IN} \qquad (1)$$

where $t_{on}$ represents the fraction of the total time period, $T_s$, that the power MOSFET 615 is turned on.

Control of power conversion is preferably achieved using a Unitrode 3803 control chip 635 manufactured by the Unitrode Corporation of Lexington, Massachusetts. A resistor 638, in combination with a pair of capacitors 641, 644, provides the resistance-capacitance ("RC") timing for the oscillator of the control chip 635. Bypass filtering for the converter circuit 600 is accomplished through a pair of resistors 647, 653 in series with a pair of capacitors 650, 656, respectively. Overall loop compensation is achieved through a pair of resistors 659, 662 in series with a pair of capacitors 660, 664, respectively. Furthermore, a voltage setpoint is obtained through the ratio of a pair of resistors 666, 668. The control chip 635, and related components, thereby acts as the controller of the converter circuit 600; the control chip 635 also provides phase correction and gain for the power stage. Finally, with respect to the power stage, a resistor 670 limits cross conduction therein.

A FET 673 is the main power FET of the circuit and, as a result, is the FET 673 that the FET protection circuit of the present invention is designed to protect. The FET 673 is preferably a Siliconix 9433 manufactured by the Siliconix Corporation of Santa Clara, California. A FET 675 provides synchronous rectification for the circuit and therein allows current to flow in the load during the off time of the FET 673. The FET 675 is preferably a Siliconix 9410, again manufactured by the Siliconix Corporation. The synchronous rectifier is employed to enhance the efficiency of the circuit. Finally, a capacitor 677 provides filtering of the output voltage 610.

In the illustrated embodiment, the FET protection circuit comprises a pair of transistors 680, 682, a resistor 684 ("a first resistive component"), a resistor 686 ("a second resistive component"), a resistor 688 and a pair of capacitors 690, 692. The transistors 680, 682 are 2907s (available from a wide array of commercial sources, for instance, the National Semiconductor Corporation of Santa Clara, California). Analogous to the circuits as described with respect to FIGUREs 4 and 5, the voltage-sense circuitry includes a voltage mirror circuit coupled in parallel with the FET 673, the main power FET. The voltage mirror circuit consists of the transistors 680, 682, the resistors 684, 686 and the capacitor 690. The voltage mirror circuit creates a voltage across the resistor 684 equivalent to the operating voltage of the FET 673. The FET protection circuit also includes the drive signal modification circuit and the voltage-sense controller as hereinafter described.

The circuit generally operates as follows. For a given voltage drop across the resistor 684, a known current flows through the resistor 686. Based upon the value of the second resistive component 686 and the known current flowing therethrough, a maximum voltage is monitored at a point X through a resistor 696 to the control chip 635. If the voltage exceeds the predetermined limit, the drive modification circuit, comprising the control chip 635, transmits a drive signal to the power MOSFET 615 to disable the FET 673. The voltage-sense controller circuit, comprising the resistor 688 and the capacitor 692, disables the FET protection circuit when the FET 673 is off. The features and advantages of the voltage-sense controller circuit are discussed with respect to FIGURE 4.

Although the present invention has been described in detail, those skilled in the art should understand that they can make various changes, substitutions and alterations herein without departing from the spirit and scope of the invention in its broadest form.

## Claims

1. A field effect transistor (FET) protection circuit for modifying a drive signal provided to a FET, comprising:

a voltage-sense circuit coupled to said FET to measure an operating voltage across said FET, said operating voltage being a function of both a magnitude of an electrical current flowing through said FET and an operating temperature of said FET; and
a drive signal modification circuit coupled to said voltage-sense circuit, said drive signal modification circuit modifying said drive signal when said operating voltage exceeds a predetermined limit voltage, said protection circuit thereby providing unified overcurrent and overtemperature protection for said FET.

2. The protection circuit as recited in Claim 1 wherein a FET drive circuit provides said drive signal to said FET.

3. A method of protecting a field effect transistor (FET), comprising the steps of:

measuring an operating voltage across said FET with a voltage-sense circuit coupled to said FET, said operating voltage being a function of both a magnitude of an electrical current flowing through said FET and an operating temperature of said FET; and

modifying a drive signal to said FET when said operating voltage exceeds a predetermined limit voltage with a drive signal modification circuit coupled to said voltage-sense circuit, thereby providing unified overcurrent and overtemperature protection for said FET.

4. The method as recited in Claim 3 wherein said step of measuirng comprises the step of coupling a voltage mirror circuit in parallel with said FET, said voltage mirror circuit creating a voltage therein equivalent to said operating voltage of said FET.

5. The method as recited in Claim 3 wherein said FET is a metal oxide semiconductor FET (MOSFET).

6. The method as recited in Claim 3 further comprising the step of disabling said drive signal modification circuit when said FET is in an "off" state with a voltage-sense controller circuit coupled to said drive signal modification circuit.

7. The method as recited in Claim 3 further comprising the step of providing said drive signal to said FET with a FET drive circuit.

8. The method as recited in Claim 3 wherein said step of measuring comprises the steps of:

coupling first and second transistors together via respective control terminals thereof; and coupling a first resistive component between said FET and said second transistor.

9. The method as recited in Claim 8 wherein said drive voltage-sense circuit comprises a second resistive component having a desired resistance, said second resistive component producing a voltage across said drive signal modification circuit as a function of a current flow thereacross.

10. A power converter, comprising:

a power train having an input couplable to a source of electrical power, an output couplable to an electrical load and power conversion circuitry coupling said input to said output, said power conversion circuitry including a field effect transistor (FET), a FET drive circuit and a FET protection circuit for modifying a drive signal provided to said FET by said FET drive circuitry, said FET protection circuit comprising: a voltage-sense circuit coupled to said FET to measure an operating voltage across said FET, said operating voltage being a function of both a magnitude of an electrical current flowing through said FET and an operating temperature of said FET; and

a drive signal modification circuit coupled to said voltage-sense circuit, said drive signal modification circuit modifying said drive signal when said operating voltage exceeds a predetermined limit voltage, said protection circuit thereby providing unified overcurrent and overtemperature protection for said FET.

11. A circuit as claimed in claim 1 or a power converter as claimed in claim 10 wherein said voltage-sense circuit comprises a voltage mirror circuit coupled in parallel with said FET, said voltage mirror circuit creating a voltage therein equivalent to said operating voltage of said FET.

12. A circuit as claimed in claim 1 or a power converter as claimed in claim 10 wherein said FET is a metal oxide semiconductor FET (MOSFET).

13. A circuit as claimed in claim 1 or a power converter as claimed in claim 10 further comprising a voltage-sense controller circuit coupled to said drive signal modification circuit, for disabling said drive signal modification circuit when said FET is in an "off" state.

14. A circuit as claimed in claim 1 or a power converter as claimed in claim 10 wherein said voltage-sense circuit comprises first and second transistors coupled together via respective control terminals thereof and a first resistive component coupling said FET and said second transistor.

15. A circuit or converter claimed in claim 14 wherein said voltage-sense circuit comprises a second resistive component having a desired resistance, said second resistive component producing a voltage across said drive signal modification circuit as a function of a current flow thereacross.

## FIG. 1
(PRIOR ART)

I IN

150

100

CONTROLLER → FET DRIVE → FET

110    120    130

160

I OUT

THERMAL SENSE

140

## FIG. 2
(PRIOR ART)

I IN

210

100

CONTROLLER → FET DRIVE → FET

110    120    130

CURRENT SENSE

220

I OUT

200

## FIG. 3

I IN

340

100

CONTROLLER → FET DRIVE → FET

110    120    130

350

I OUT

300

VOLTAGE SENSE CONTROLLER

310

VOLTAGE SENSE

MOD. CIRCUIT

330    320

FIG. 4

FIG. 5

EP 0 749 208 A2

# FIG. 6

EP 0 749 208 A2